# EUROPÄISCHE PATENTANMELDUNG

(11) **EP 4 029 967 A1**
(43) Veröffentlichungstag der Anmeldung: **20.07.2022**
(21) Anmeldenummer: 22159056.5
(22) Anmeldetag: 12.01.2016
(51) Int. Cl.: C23C 4/10, C23C 4/134, H05H 1/34, H05H 1/42, C23C 4/02

(54) **STRUKTUR ODER BAUTEIL FÜR HOCHTEMPERATURANWENDUNGEN SOWIE VERFAHREN UND VORRICHTUNG ZUR HERSTELLUNG DERSELBEN**

(30) Priorität: 13.01.2015 DE 102015100441
(62) Teilanmeldung aus: 16150888.2
(71) Anmelder: Airbus Defence and Space GmbH, 82024 Taufkirchen (DE)
(72) Erfinder: Steinwandel, Jürgen, 88690 Uhldingen-Mühlhofen (DE); Wilhelmi, Christian, 85635 Höhenkirchen-Siegertsbrunn (DE); Uhlmann, Franziska, 81479 München (DE); Laure, Stefan, 70329 Stuttgart (DE)
(74) Vertreter: KASTEL Patentanwälte PartG mbB

(57) **Zusammenfassung**

Um Strukturen zu schaffen, die Hochtemperaturanwendungen mit höheren Prozesstemperaturen und schwierigen chemischen Bedingungen Stand halten, schafft die Erfindung eine Struktur für Hochtemperaturanwendungen, umfassend eine Grundstruktur, die ein keramisches Verbundmaterial aufweist und eine Beschichtung aus einer Metall-Halbmetallverbindung, einem Metallborid und/oder einem Metallcarbid und/oder einem Metallnitrid. Weiter werden ein Herstellverfahren sowie eine Beschichtungsvorrichtung zur Verwendung darin beschrieben.

## Beschreibung

Die Erfindung betrifft eine Struktur oder Bauteil für Hochtemperaturanwendungen sowie ein Verfahren zur Herstellung einer Struktur oder eines Bauteils für Hochtemperaturanwendungen, wie insbesondere für Brennkammern und/oder andere Anwendungen wie z.B. weitere Triebwerkskomponenten, Komponenten für Hyperschallantriebe/Hyperschall-Vehicle, Thermalschutzsysteme für den Re-Entry-Bereich usw., mehr insbesondere für die Luft- und/oder Raumfahrt. Weiter betrifft die Erfindung ein Verfahren und eine Vorrichtung zur Beschichtung einer Grundstruktur.

Brennkammern von Triebwerken für Kraftmaschinen, Fahrzeuge, Luftfahrzeuge und Raumfahrzeuge, wie z.B. Raketen, müssen im Betrieb hohen thermo-mechanischen und thermo-chemischen Belastungen standhalten.

US 2010/0266781 A1 offenbart ein Verfahren zur Verbesserung der Korrosion, der Abrasion und der Feuerfestigkeit von Strukturkomponenten zur Verwendung unter anderem in petrochemischen Anwendungen.

DE 603 07 254 T2 betrifft das Aufbringen einer Schutzbeschichtung gegen Oxidation auf Stücke bzw. Teile aus thermostrukturierten Kompositmaterialien.

Ein Verfahren zum Aufbringen einer mehrlagigen Beschichtung auf Werkstücke und/oder Werkstoffe findet man in DE 10 2007 058 484 A1. In der deutschen OS 1 571 171 wird eine Plasmaspritzpistole beschrieben. Ein Verfahren zur Herstellung von thermischen rauhen Sprühbeschichtungen wird in DE 695 22 098 T2 offenbart. Weiterhin beschreibt US 2007/0275267 A1 eine mechanische Verschlussstruktur mit mindestens einer keramischen Verschlussfläche. US 5,780,157 offenbart eine feuerfeste Kompositstruktur, die unter Anwendung von chemischer Gasphasenabscheidung (CVD) hergestellt wird.

CN 103 922 745 A offenbart ein ZrB₂-SiC-beschichtetes Kohlefaser-Kohlenstoff-Verbundmaterial. Die ZrB₂-SiC-Beschichtung wird durch Ultraschallplasmaspritzen unter Verwendung eines ZrB₂-SiC-Granulats aufgebracht.

US 5,573,682 offenbart eine Überschalldüse (Laval-Düse) für eine Ultraschall-Plasmaspritz-Vorrichtung, mit der der nachteilige seitliche Overspray von Pulverpartikeln nach Austritt des Plasmastrahls aus der Überschalldüse vermieden werden soll. Hierfür ist der Expansionsabschnitt der Überschalldüse glockenförmig ausgebildet. Die Zufuhröffnungen für die Zufuhr des Beschichtungsmaterials sind im glockenförmigen Expansionsabschnitt der Überschalldüse angeordnet.

Der Erfindung liegt die Aufgabe zugrunde, ein Strukturbauteil für Hochtemperaturanwendungen zu schaffen, das die obigen Voraussetzungen bei leichtgewichtigem Aufbau erfüllt und mit dem zudem noch höhere Betriebstemperaturen als bisher ermöglicht sind.

Hierzu schlägt die Erfindung ein Strukturbauteil nach Anspruch 1 sowie ein Herstellverfahren zum Herstellen von Strukturen für Hochtemperaturanwendung nach dem Nebenanspruch sowie eine Vorrichtung zum Durchführen zumindest von Teilschritten des Herstellverfahrens insbesondere zum Durchführen einer Beschichtung nach dem weiteren Nebenanspruch vor. Vorteilhafte Ausgestaltungen der Erfindung sind Gegenstände der Unteransprüche.

Gemäß einem ersten Aspekt schafft die Erfindung eine Struktur für Hochtemperaturanwendung, umfassend eine Grundstruktur, die ein keramisches Verbundmaterial aufweist und eine Beschichtung aus einem Beschichtungsmaterial, das wenigstens eine Metall-Halbmetallverbindung, wenigstens ein Metallborid, wenigstens ein Metallcarbid und/oder wenigstens ein Metallnitrid enthält.

Es ist bevorzugt, dass die Grundstruktur Fasern und eine Matrix aufweist und/oder dass die Beschichtung eine Dicke von 0,1 µm bis 200 µm aufweist.

Es ist bevorzugt, dass die Fasern gebildet sind aus einem oder mehreren Fasermaterialien, die ausgewählt sind aus einer Gruppe von Fasermaterialien, die C, keramische Materialien, SiC, HfC, ZrC, TaC, TiC, ZrB₂, HfB₂, TiB₂, TaB₂ und NbB₂ und nitridische Materialien umfasst.

Es ist bevorzugt, dass die Matrix gebildet ist aus einem oder mehreren Matrixmaterialien, die ausgewählt sind aus einer Gruppe von Matrixmaterialien, die C, keramischen Matrixmaterialien, SiC, SiSiC, HfC, ZrC, TaC, TiC, ZrB₂, HfB₂, TiB₂, TaB₂ und NbB₂ und nitridische Materialien umfasst.

Es ist bevorzugt, dass die Beschichtung aus einem Metallborid gebildet ist.

Es ist bevorzugt, dass die Beschichtung aus einem Metallcarbid gebildet ist.

Es ist bevorzugt, dass die Beschichtung ausgewählt ist aus einem oder mehreren der Beschichtungsmaterialien einer Gruppe von Beschichtungsmaterialien, die SiC, HfC, ZrC, TaC, TiC, ZrB₂, HfB₂, TiB₂, TaB₂ und NbB₂ und nitridische Materialien umfasst.

Es ist bevorzugt, dass die Beschichtung aus ZrB₂ und SiC gebildet ist.

Es ist bevorzugt, dass die Grundstruktur Carbonfasern C_{f} und eine SiC-Matrix umfasst.

Es ist bevorzugt, dass die Beschichtung wenigstens eine glasartige Substanz aufweist.

Es ist bevorzugt, dass die Beschichtung wenigstens eine gradierte Oberfläche aufweist.

Es ist bevorzugt, dass die Beschichtung wenigstens eine Mischung eines Metalloxids mit Boroxid oder Halbmetalloxid an ihrer Oberfläche aufweist.

Es ist bevorzugt, dass die oben beschriebenen erfindungsgemäßen Strukturen nach einem erfindungsgemäßen Verfahren gemäß dem folgenden zweiten Aspekt erhältlich sind.

Gemäß einem zweiten Aspekt schafft die Erfindung ein Verfahren zum Herstellen einer Struktur für Hochtemperaturanwendungen, umfassend:
a) Bereitstellen einer Grundstruktur aus einem keramischen Verbundmaterial, insbesondere keramischen Faserverbundmaterial, und
b) Beschichten der Grundstruktur mit einer UHTC-Beschichtung.

Es ist bevorzugt, dass Schritt a) umfasst:
a1) Bereitstellen von Fasern aus einem oder mehreren Fasermaterialien, die ausgewählt sind aus einer Gruppe von Fasermaterialien, die C, keramische Materialien, SiC, HfC, ZrC, TaC, TiC, ZrB₂, HfB₂, TiB₂, TaB₂ und NbB₂ und nitridische Materialien umfasst.

Es ist bevorzugt, dass Schritt a) umfasst:
a2) Einbetten von Fasern in eine Matrix, wobei die Matrix gebildet wird aus einem oder mehreren Matrixmaterialien, die ausgewählt sind aus einer Gruppe von keramischen Matrixmaterialien, die SiC, HfC, ZrC, TaC, TiC, ZrB₂, HfB₂, TiB₂, TaB₂ und NbB₂ und nitridische Materialien umfasst.

Es ist bevorzugt, dass Schritt b) umfasst:
b1) Vorreinigen der Grundstruktur, insbesondere mit organischen und/oder anorganischen Lösungsmitteln und/oder mit wenigstens einer Säure.

Es ist bevorzugt, dass Schritt b) umfasst:
b2) Vorbehandeln und Vorbereiten der Grundstruktur zum Beschichten.

Es ist bevorzugt, dass Schritt b) umfasst:
b3) Einbau der Grundstruktur in eine Vakuum-Prozesskammer für Plasma-Strahltrechniken.

Es ist bevorzugt, dass Schritt b) umfasst:
b4) Vorheizen der Grundstruktur.

Es ist bevorzugt, dass Schritt b) umfasst:
b5) Behandlung der Grundstruktur mittels reaktiven Plasmastrahlen.

Es ist bevorzugt, dass Schritt b) umfasst:
b6) Beschichtung der Grundstruktur mit wenigstens einem Metallborid und/oder einem Metallcarbid und/oder mit einem Beschichtungsmaterial, das ausgewählt ist aus einem oder mehreren der Beschichtungsmaterialien einer Gruppe von Beschichtungsmaterialien, die SiC, HfC, ZrC, TaC, TiC, ZrB₂, HfB₂, TiB₂, TaB₂ und NbB₂ und nitridische Materialien umfasst.

Es ist bevorzugt, dass Schritt b6) umfasst:
b6.1) Verwenden eines Pulvers oder einer Pulvermischung mit einer mittleren Korngröße von 1 µm bis 100 µm als Beschichtungsmaterial - insbesondere aus der Metall-Halbmetallverbindung und mehr insbesondere aus dem Metallborid.

Es ist bevorzugt, dass Schritt b6) umfasst:
b6.2) Verbringen des Beschichtungsmaterials, insbesondere in Pulverform, mittels einer Fördereinrichtung in einen Plasmabrenner.

Es ist bevorzugt, dass Schritt b6) umfasst:
b6.3) Verwenden eines Plasmabrenners mit einem länglichen Plasmakanal hinter einer Wolfram-Kathode, in den das Beschichtungsmaterial eingebracht wird.

Es ist bevorzugt, dass Schritt b6) umfasst:
b6.4) Einbringen des Beschichtungsmaterials stromabwärts einer Kathode, um einen Kontakt der Kathode mit dem Beschichtungsmaterial zu vermeiden.

Es ist bevorzugt, dass Schritt b6) umfasst:
b6.5) Fragmentieren und/oder teilweises Verdampfen des Beschichtungsmaterials in einem heißen Kernstrahl des Plasmas, insbesondere zum Erzeugen eines Cluster-Gases, mehr insbesondere aus Nano-Aggregaten des Beschichtungsmaterials, wie z.B. Metallborid, in Verbindung mit einfachen Metall-Halbmetallmolekülen (z.B. des Typs Me-B) sowie Metallatomen und Halbmetallatomen (z.B. Boratomen).

Es ist bevorzugt, dass Schritt b6) umfasst:
b6.6) Expandieren der Gasmischung mit Beschichtungsmaterial über eine Überschall-Düse.

Es ist bevorzugt, dass Schritt b6) umfasst:
b6.7) Durchführen eines Überschallverfahrens zum Konzentrieren schwerer Bestandteile des Clustergases oder der Gasmischung mit Beschichtungsmaterial im Zentrum des Gasstrahls.

Es ist bevorzugt, dass Schritt b4) umfasst:
b4.1) Vorheizen mittels Enthalpie und/oder Temperatur eines Plasmastrahls.

Es ist bevorzugt, dass Schritt b4) umfasst:
b4.2) Variation der Plasmaleistung in Abhängigkeit von der Prozessdauer und/oder der Verdampfungsenthalpie und/oder der Fragmentierungsenthalpie des Beschichtungsmaterials.

Es ist bevorzugt, dass Schritt b4) umfasst:
b4.3) unmittelbares elektrisches Heizen der Grundstruktur durch Einleiten eines Heizstromes in die Grundstruktur.

Es ist bevorzugt, dass Schritt b4) umfasst:
b4.4) Erwärmen und/oder Warmhalten der Grundstruktur auf eine Prozesstemperatur im Bereich von 300°C und 1400°C und mehr insbesodere im Bereich von 500°C und 1100°C.

Es ist bevorzugt, dass Schritt b4) umfasst:
b4.5) Erfassen der Temperatur der Grundstruktur, vorzugsweise mittels wenigstens einen Thermoelements, und Regeln des Heizprozesses.

Es ist bevorzugt, dass das Verfahren umfasst:
c) oberflächliche Umwandlung des Metall-Halbmetall-Beschichtungsmaterials, wie insbesondere Boriden, mittels Sauerstoff zu einer glasartigen Substanz und/oder in Mischungen von Metalloxiden mit Halbmetalloxid, insbesondere Boroxid.

Gemäß einem dritten Aspekt schafft die Erfindung eine Vorrichtung zur Verwendung in einem erfindungsgemäßen Verfahren, insbesondere zum Durchführen von Schritt b), umfassend:
eine Prozesskammer, einer Plasmastrahlerzeugungseinrichtung mit einer Kathode und einem länglichen Plasmakanal stromab der Kathode zum Leiten eines Plasmastrahls sowie einer Beschichtungsmaterialeinbringungseinrichtung zum Einbringen von Beschichtungsmaterial stromab der Kathode.

Die Vorrichtung umfasst bevorzugt wenigstens ein Strömungskörper zum Leiten des Plasmastrahls mehr in Richtung zu einer zu beschichtenden Wandung der Grundstruktur.

### Klausel 1:

Verfahren zum Herstellen einer Struktur (1) für Hochtemperaturanwendungen, umfassend:
a) Bereitstellen einer Grundstruktur (2) aus einem keramischen Verbundmaterial, insbesondere keramischen Faserverbundmaterial, und
b) Beschichten der Grundstruktur (2) mit einer UHTC-Beschichtung (3).

### Klausel 2:

Verfahren nach Klausel 1, dadurch gekennzeichnet, dass Schritt a) wenigstens einen, mehrere oder alle der folgenden Schritte umfasst:
a1) Bereitstellen von Fasern aus einem oder mehreren Fasermaterialien, die ausgewählt sind aus einer Gruppe von Fasermaterialien, die C, keramische Materialien, SiC, HfC, ZrC, TaC, TiC, ZrB₂, HfB₂, TiB₂, TaB₂ und NbB₂ und nitridische Materialien umfasst,
a2) Einbetten von Fasern in eine Matrix, wobei die Matrix gebildet wird aus einem oder mehreren Matrixmaterialien, die ausgewählt sind aus einer Gruppe von keramischen Matrixmaterialien, die SiC, HfC, ZrC, TaC, TiC, ZrB₂, HfB₂, TiB₂, TaB₂ und NbB₂ und nitridische Materialien umfasst.

### Klausel 3:

Verfahren nach Klausel 1 oder 2, dadurch gekennzeichnet, dass Schritt b) wenigstens einen, mehrere oder alle der folgenden Schritte umfasst:
b1) Vorreinigen der Grundstruktur (2) , insbesondere mit organischen und/oder anorganischen Lösungsmitteln und/oder mit wenigstens einer Säure;
b2) Vorbehandeln und Vorbereiten der Grundstruktur (2) zum Beschichten,
b3) Einbau der Grundstruktur (2) in eine Vakuum-Prozesskammer (10) für Plasma-Strahltrechniken;
b4) Vorheizen der Grundstruktur (2) ;
b5) Behandlung der Grundstruktur (2) mittels reaktiven Plasmastrahlen
b6) Beschichtung der Grundstruktur (2) mit wenigstens einem Metallborid
und/oder einem Metallcarbid und/oder mit einem Beschichtungsmaterial, das ausgewählt ist aus einem oder mehreren der Beschichtungsmaterialien einer Gruppe von Beschichtungsmaterialien, die SiC, HfC, ZrC, TaC, TiC, ZrB₂, HfB₂, TiB₂, TaB₂ und NbB₂ und nitridische Materialien umfasst.

### Klausel 4:

Verfahren nach Klausel 3, dadurch gekennzeichnet, dass Schritt b6) wenigstens einen, mehrere oder alle der folgenden Schritte umfasst:
b6.1) Verwenden eines Pulvers oder einer Pulvermischung mit einer mittleren Korngröße von 1 µm bis 100 µm als Beschichtungsmaterial - insbesondere aus der Metall-Halbmetallverbindung und mehr insbesondere aus dem Metallborid,
b6.2) Verbringen des Beschichtungsmaterials, insbesondere in Pulverform, mittels einer Fördereinrichtung in einen Plasmabrenner (4),
b6.3) Verwenden eines Plasmabrenners (4) mit einem länglichen Plasmakanal hinter einer Wolfram-Kathode, in den das Beschichtungsmaterial eingebracht wird,
b6.4) Einbringen des Beschichtungsmaterials stromabwärts einer Kathode, um einen Kontakt der Kathode mit dem Beschichtungsmaterial zu vermeiden,
b6.5) Fragmentieren und/oder teilweises Verdampfen des Beschichtungsmaterials in einem heißen Kernstrahl des Plasmas, insbesondere zum Erzeugen eines Cluster-Gases, mehr insbesondere aus Nano-Aggregaten des Beschichtungsmaterials, wie z.B. Metallborid, in Verbindung mit einfachen Metall-Halbmetallmolekülen (z.B. des Typs Me-B) sowie Metallatomen und Halbmetallatomen (z.B. Boratomen),
b6.6) Expandieren der Gasmischung mit Beschichtungsmaterial über eine Überschall-Düse,
b6.7) Durchführen eines Überschallverfahrens zum Konzentrieren schwerer Bestandteile des Clustergases oder der Gasmischung mit Beschichtungsmaterial im Zentrum des Gasstrahls;
und/oder dass Schritt b4) einen, mehrere oder alle der folgenden Schritte umfasst:
b4.1) Vorheizen mittels Enthalpie und/oder Temperatur eines Plasmastrahls,
b4.2) Variation der Plasmaleistung in Abhängigkeit von der Prozessdauer und/oder der Verdampfungsenthalpie und/oder der Fragmentierungsenthalpie des Beschichtungsmaterials,
b4.3) unmittelbares elektrisches Heizen der Grundstruktur (2) durch Einleiten eines Heizstromes in die Grundstruktur,
b4.4) Erwärmen und/oder Warmhalten der Grundstruktur (2) auf eine Prozesstemperatur im Bereich von 300 °C und 1400 °C und mehr insbesondere im Bereich von 500 °C und 1100 °C,
b4.5) Erfassen der Temperatur der Grundstruktur (2), vorzugsweise mittels wenigstens einen Thermoelements, und Regeln des Heizprozesses.

### Klausel 5:

Verfahren nach einer der Klauseln 1 bis 4, gekennzeichnet durch
c) oberflächliche Umwandlung des Metall-Halbmetall-Beschichtungsmaterials, wie insbesondere Boriden, mittels Sauerstoff zu einer glasartigen Substanz und/oder in Mischungen von Metalloxiden mit Halbmetalloxid, insbesondere Boroxid.

### Klausel 6:

Vorrichtung zur Verwendung in einem Verfahren nach einer der Klauseln 1 bis 5, insbesondere zum Durchführen von Schritt b), umfassend eine Prozesskammer, einer Plasmastrahlerzeugungseinrichtung mit einer Kathode (5) und einem länglichen Plasmakanal stromab der Kathode (5) zum Leiten eines Plasmastrahls sowie einer Beschichtungsmaterialeinbringungseinrichtung zum Einbringen von Beschichtungsmaterial stromab der Kathode (5).

### Klausel 7:

Vorrichtung nach Klausel 6, gekennzeichnet durch wenigstens eine Strömungskörper zum Leiten des Plasmastrahls mehr in Richtung zu einer zu beschichtenden Wandung der Grundstruktur (2).

Bevorzugte Ausführungsbeispiele der Erfindung werden im Folgenden anhand der beigefügten Zeichnungen näher erläutert. Darin zeigt:
- Fig. 1: eine schematische Schnittdarstellung einer Ausführungsform einer Struktur für Hochtemperaturanwendungen;
- Fig. 2: eine schematische Darstellung einer Ausführungsform eines Lichtbogenbrenners zur Verwendung in einer Beschichtungsapparatur zum Beschichten einer Grundstruktur mit einer UHTC-Schicht, um so die Struktur von Fig. 1 zu erhalten; und
- Fig. 3: eine schematische Darstellung einer Ausführungsform der Beschichtungsapparatur.

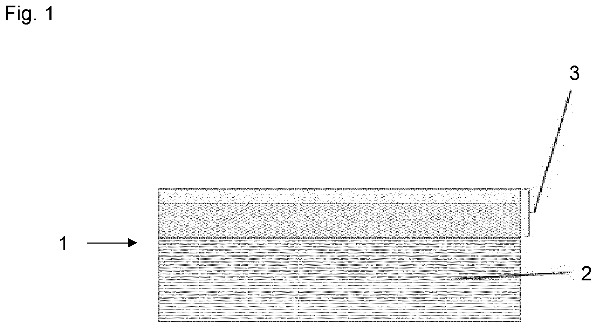

Eine Ausführungsform einer bevorzugten Struktur 1 für Hochtemperaturbeschichtungen ist in Fig. 1 dargestellt. Die Struktur 1 weist eine Grundstruktur 2 aus einem keramischen Faserverbundmaterial und eine Beschichtung 3 aus einer Hochtemperaturkeramik (UHTC = Ultra High Temperature Coating) auf. Die Beschichtung 3 kann gradiert oder nicht gradiert sein. Sie ist jedoch vorzugsweise gradiert. Sie besteht beispielsweise aus Metallboriden, insbesondere ZrB₂, und/oder Metallcarbiden, wie z. B. SiC, TaC, oder Mischungen daraus, oder Metallnitriden. Bei dem keramischen Verbundwerkstoff (CMC = Ceramic Matrix Composite) handelt es sich insbesondere um Cf/SiC.

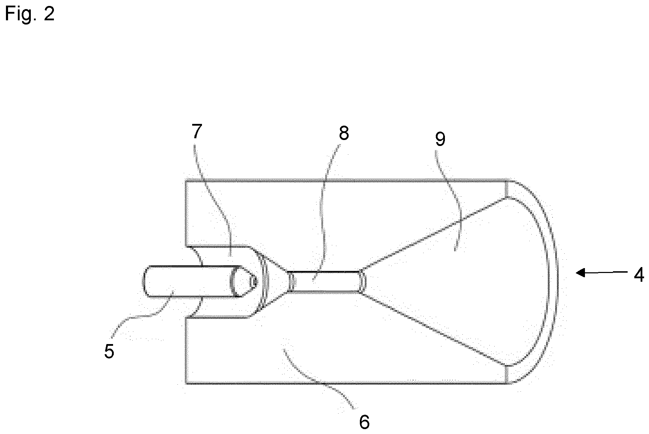

Fig. 2 zeigt einen Lichtbogenbrenner 4 zur Verwendung in einer Beschichtungsapparatur. Der Lichtbogenbrenner 4 gemäß Fig. 2 umfasst eine Kathode 5, eine Anode 6, eine Brennkammer 7, einen Düsenhals 8 und eine Expansionsdüse 9.

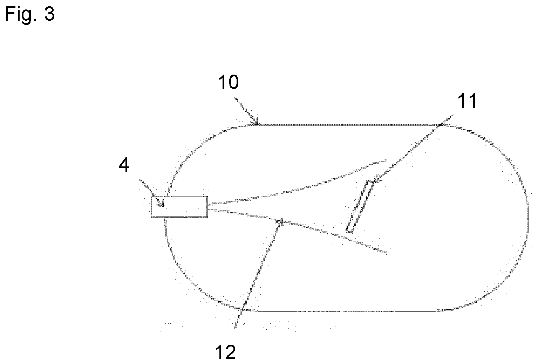

Fig. 3 zeigt eine Beschichtungsapparatur, in der der Lichtbogenbrenner 4 angeordnet ist, die weiterhin einen Vakuumtank 10 umfasst, in dem ein Flachprobenhalter 11 angeordnet wird. Für die Beschichtung, beispielsweise mit ZrB₂, verlässt der divergente Plasma-Keramik-Strahl 12 den Lichtbogenbrenner 4 und trifft auf eine Flachprobe in einem Flachprobenhalter 11.

Im Folgenden werden der Aufbau und die Herstellung von bevorzugten Strukturen für Hochtemperaturanwendungen näher erläutert.

Hierzu wird zunächst erläutert, für welche Anwendungsfälle die Strukturen besonders geeignet und optimiert sind, woraus sich für den Fachmann typische Aufbauten der Strukturen und der entsprechend daraus aufgebauten Strukturbauteile ergeben. Anschließend werden bevorzugte Materialien und die Herstellweise der hier vorgeschlagenen Strukturen näher erläutert.

Die Strukturen und Strukturbauteile sollen für Hochtemperaturanwendungen wie sie insbesondere im Zusammenhang mit technischen Verbrennungen und Brennkraftmaschinen vorkommen angewandt werden. Insbesondere sind die Strukturen als Bauteile oder Strukturbauteile von Brennkammern oder als Strukturbauteile in der Nähe von Brennkammern ausgebildet.

Die Effizienz von technischen Verbrennungen hängt u.a. entscheidend davon ab, inwieweit hohe Verbrennungstemperaturen, bzw. Drucke erzielt werden können. Das ist insbesondere einsichtig, wenn es sich um thermodynamische Kreisprozesse handelt.

Als ein Beispiel ist ein Joule-Brayton-Prozess bei Fluggasturbinen zu nennen. Als ein weiteres Beispiel ist ein Raketentriebwerk zu nennen.

Bei einem Raketentriebwerk wird die Nutzleistung über eine adiabatische Expansion erzielt, die ihrerseits auch wieder möglichst hohe Drucke und Temperaturen in der Brennkammer erfordert.

Es hängt nun dabei entscheidend davon ab, wie hoch die Temperaturbelastung der jeweiligen Strukturwerkstoffe getrieben werden kann. Die Strukturtemperatur entspricht dabei in der Regel nicht der Gastemperatur, sondern ist geringer.

Derzeit werden als Strukturwerkstoffe für derartige Anwendungen z.B. Hochtemperaturlegierungen eingesetzt. Typische Hochtemperaturlegierungen, wie sie in der derzeitigen Praxis - z.B. in Triebwerken von Flugzeugen von Airbus - beispielsweise im Bereich der Fluggasturbinen eingesetzt werden, sind Nickel- oder Kobalt- Basislegierungen. Diese sind bis ca. 1200°C (Oberflächen- bzw. Strukturtemperatur) im Dauerbetrieb einsetzbar. Einen höheren Temperaturteinsatzbereich weisen z. B. Nickel - Aluminide (bis ca. 1.300°C) und Niob-bzw. Tantal auf (bis ca. 1.400°C). Diese Temperaturen hängen stark von der jeweiligen Legierungszusammensetzung, aber auch von der Kristallstruktur (z. B. Einkristallmaterialien vs. polykristallinen Materialien sowie der (meist thermischen) Nachbehandlung ab.

Die abnehmende Festigkeit metallischer Werkstoffe bei höheren Temperaturen (u.a. bedingt durch die thermisch induzierten Fehlstellen - Schottky und Frenkel-Defekte-) ist entscheidend für die Strukturstabilität. Darüber hinaus gibt es noch weitere Stabilitätskriterien. Insbesondere sind hier die Oxidations- und HeißgasKorrosionsbeständigkeit anzuführen. Diese chemisch induzierten Effekte treten bei allen technischen Verbrennungen auf. Der Restsauerstoff einer technischen Verbrennung hängt dabei von der Verbrennungsführung ab. Die Spannweite ist dabei relativ groß und kann von quasi- stöchiometrisch/leicht überstöchiometrisch (Beispiele hier sind Verbrennungen in Ottomotoren oder Raketentriebwerken) bis hin zu hoch überstöchiometrischen Verbrennungen reichen (Beispiele hier sind Otto-Magerverbrennungen, Dieselmotorische und Gasturbinenverbrennungen).

Insgesamt ist festzustellen, dass im Hinblick auf eine Erweiterung des Temperatur-Einsatzbereichs metallische Werkstoffe am Ende ihres Einsatzbereiches angelangt sind. Ein gemäß einem Ausführungsbeispiel verfolgter Ansatz zur Lösung ist, auf keramische Werkstoffe überzugehen. Insbesondere von Interesse hier sind Faserverbundwerkstoffe.

Im Zusammenhang mit der vorgesehenen Anwendung haben sich unbehandelte Faserverbundwerkstoff als wenig geeignet erwiesen. Vielmehr werden gemäß einem Ausführungsbeispiel Beschichtungen aus hochtemperaturfesten und insbesondere oxidationsbeständigen Materialien vorgeschlagen.

Die bisher üblichen metallischen oder intermetallischen Hochtemperaturwerkstoffe weisen bei Temperaturen oberhalb 1.400 °C (Bauteiltemperatur, Gastemperatur als Richtwert ca. 150 - 200 °C höher) keine ausreichende Festigkeit und darüber hinaus auch keine hinreichende Oxidationsbeständigkeit auf. Im Hinblick auf den Einsatz in Gasturbinen ist dies z.B. in der Hochdruckturbine bisher auch nur mit Filmkühlung durch Verdichterluft realisierbar. Bei Raketentriebwerken (z.B. Vulcain2) ist eine Innenkühlung nicht darstellbar. Stattdessen erfolgt hier eine Aussenkühlung der Brennkammer und Schubdüse mittels Cryo-Wasserstoff vor Eintritt in die Brennkammer. Innenbeschichtungen sind erforderlich, um die Heißgas- Korrosionsbeständigkeit zu erhöhen um damit die Lebensdauer zu verlängern. Die vorangestellten Nachteile sollen durch die hier vorgeschlagenen Strukturwerkstoffe vermieden oder zumindest gemildert werden.

Bei kleineren Triebwerken kann das Problem der Temperatur/ Heißgas- Korrosionsbeständigkeit auch durch die Verwendung von hochschmelzenden Edelmetallen (Pt, Os, Ir) als Einheit Brennkammer/Schubdüse gelöst werden, was jedoch äußerst kostenintensiv ist. Parallelen dazu sind als Beschichtungen im Gasturbinenbereich (Hochdruckturbine) bekannt (z.B. Pt/Al).

Bei einem Ausführungsbeispiel werden zum Erlangen höherer Temperatur-Dauerbelastungen keramische Materialien, insbesondere "Ultra high temperature ceramics", kurz: UHTCs, mit Schmelzpunkten oberhalb 3000 °C eingesetzt. Bevorzugte Beispiele dazu sind SiC, ZrC, HfC, TaC, TiC, ZrB₂, HfB₂, TiB₂, TaB₂ und NbB₂. Darüber hinaus können auch nitridische Verbindungen eingesetzt werden.

Es ist grundsätzlich möglich, diese Materialien als monolithische Keramiken einzusetzen. Insbesondere werden z.B. bei der in Fig. 1 dargestellten Struktur diese Materialien als Beschichtungen eingesetzt.

Für den hier vorgeschlagenen Anwendungsfall wird gemäß einem weiter bevorzugten Ausführungsbeispiel eine Grundstruktur aus einer Faserkeramik benutzt. Diese Grundstruktur weist vorzugsweise Kohlenstoff-Langfasern mit einer Matrix aus Siliciumcarbid (C/SIC) auf. Alternativ kommen neben anderen weiteren Materialkombinationsmöglichkeiten beispielsweise noch folgende Materialkombinationen in Betracht:
1. SiC-Fasern mit SiC Matrix (SiC/SiC)
2. C-Fasern mit HfC Matrix (C/HfC)
3. SiC-Fasern mit HfC Matrix (SiC/HfC)
4. HfC-Fasern mit HfC Matrix ( HfC/HfC)
5. HfC-Fasern mit SiC Matrix (HfC/SiC)
6. Weitere Materialien/Materialkombinationen analog zur Beschichtung (zb ZrB₂).

Auch für die Matrix und gegebenenfalls auch für die Fasern können die oben als Beispiele für die Beschichtung genannten bevorzugten Materialien wie Metallboride, Metallcarbide, Metallnitride und insbesondere sind SiC, ZrC, HfC, TaC, TiC, ZrB₂, HfB₂, TiB₂, TaB₂ und NbB₂ sowie nitridische Verbindungen verwendet werden.

Für Matrix und/oder Beschichtung sind bevorzugt Übergangsmetallboride, Übergangsmetallcarbide, entsprechende Nitride sowie Mischungen daraus einsetzbar. Auch die Fasermaterialien können diese Materialien und zusätzlich noch Kohlenstoff, insbesondere in Form von Kohlenstofflangfasern umfassen.

Diese Materialien/Materialkombinationen sind zwar thermisch stabil, für den vorgesehene Anwendungsfall wird gemäß einem besonders bevorzugten Ausführungsbeispiel jedoch weiter noch ein Schutz gegenüber Oxidation (Restsauerstoff im Brenngas) und/oder Heißgas- Korrosion (andere Verbrennungsprodukte) vorgeschlagen.

Dazu wird gemäß einem bevorzugten Ausführungsbeispiel eine stabile Beschichtung, die aus hochschmelzenden Metallboriden und/oder Übergangsmetallboriden, insbesondere Zirkon-Borid, Titan- Borid und Hafnium-Borid, oder Mischungen mit anderen Materialien wie z.B. SiC, TaC..., besteht oder derartige Metallboride oder dergleichen umfasst, auf die faserkeramische Struktur aufgebracht. Bei einer Ausgestaltung wird ein Oxidationsschutz durch eine oberflächliche Umwandlung der Boride mittels Sauerstoff zu glasartigen Substanzen erreicht, z.B. durch Mischungen der Metalloxide mit Bor-Oxid. In Fig. 1 ist dies durch die gezeigte gradierte Oberfläche angedeutet. Der Gradierschritt kann, muss aber nicht vorgesehen sein.

Die Grundstruktur wird insbesondere mit einem Verfahren hergestellt, wie es in der DE 10 2010 055 248 B4 genauer beschrieben und gezeigt ist.

Ein bevorzugtes Ausführungsbeispiel eines Herstellverfahrens oder Beschichtungsverfahrens zur Beschichtung der faserkeramischen Strukturen weist einen, mehrere oder alle der folgenden Schritte auf, wobei die in den einzelnen Schritten genannten Unterschritte bevorzugte Ausgestaltungen betreffen, die vorhanden sein können oder auch weggelassen oder modifiziert werden können:
1. Vorbereitung der Faser-Strukturen zur Beschichtung (z.B. aus der Gasphase) durch Anwendung üblicher Oberflächen-Vorbehandlungen wie z.b. Sandstrahlen, Polieren, Laserstrukturierung oder andere sowie Vorreinigungsverfahren mit organischen und/oder anorganischen Lösemitteln bzw. Säuren oder mit Laser (für näher Einzelheiten zur möglichen Laserstrukturierung wird ausdrücklich auf die DE 10 2012 016 203 A1 verwiesen, diese bildet Teil der hiesigen Offenbarung, entsprechend vorstrukturierte Oberflächen bieten eine enorm gute Adhäsionsfähigkeit)
2. Einbau der derart vorbereiteten Strukturen in eine Vakuum-Prozesskammer für Plasma-Strahltechniken (Freistrahl oder Konturdüse). Behandlung der zu beschichtenden Strukturen mittels reaktiven Plasmastrahlen (Edelgase, insbesondere Argon als primäre Gaskomponente; Sauerstoff, Stickstoff, Wasserstoff als Begleitkomponenten im Bereich 1 - 30 vol% bezogen auf den Edelgasanteil)
3. Beschichtung der Basisstrukturen mit den relevanten Metallboriden und/oder anderen keramischen Materialien oder Mischungen daraus. Dazu werden Pulver, bzw. Pulvermischungen und/oder Granulate mit einer mittleren Korngrösse 1 µm - 100 µm eingesetzt. Die Pulver werden mittels üblicher Fördereinrichtungen in eine Hochleistungs- Plasmabrenner verbracht. Das Verfahren ist abweichend vom normalen Plasmaspritzen, wo die Pulver am Strahlausgang in das expandierende Medium eingebracht werden. Entsprechende Plasmabrenner weisen eine grundsätzlich andere Bauart auf. Kernstück hier ist ein langer Plasmakanal hinter einer Wolfram- Kathode in den die Pulvermischungen eingebracht werden. Dies erfolgt stromabwärts wodurch ein Kontakt der Pulver mit der Wolframkathode vermieden wird. Das ist eine besonderer Vorteil für eine besonders gute Funktionalität des Verfahrens, da anderweitig Wolfram mit den Pulvern legieren kann und die Kathode dadurch beeinträchtigt werden oder im Extremfall gar zerstört werden kann.

Die Borid-Pulver (bzw. Pulver aus anderen hier erwähnten Beschichtungsmaterialien oder Pulvermischungen aus den genannten Beschichtungsmaterialien) werden in dem heißen Kernstrahl des Plasmas fragmentiert und teilweise verdampft. Das Resultat dieses Prozesses ist ein sogenanntes "Clustergas" bestehend aus Nano-Aggregaten der Beschichtungsmaterialien wie z.B. Metallboride (zwischen 10 nm und 10.000 nm Durchmesser in Verbindung mit einfachen Metall-Bormolekülen des Typs Me-B sowie Metallatomen und Boratomen). Diese Gasmischung wird durch eine Überschall-Düse expandiert, wobei bekanntermaßen die Machzahl über den Divergenzwinkel bzw. das Verhältnis Düsenhals- Geometrie zu Düsenausgang- Geometrie gegeben ist. Eine weitere notwendige Bedingung zur Ausbildung einer Überschallströmung ist das Druckverhältnis zwischen Plasmabrenner/Austritt (zwischen 0,5 und 10 bar und dem statischen Druck der Arbeitskammer (mindestens ein Faktor 30) erforderlich. Dieses Überschallverfahren führt zu einer Konzentration der schweren Bestandteile des "Clustergases" im Zentrum des expandierenden Plasmastrahls. Dadurch entsteht ein gerichteter Plasmajet des Clustergases mit sehr guter Durchmischung der abzuscheidenden Komponenten.

4. Die zu beschichtenden Strukturen werden bevorzugt vorgeheizt. Dazu kann die hohe Enthalpie/Temperatur des Plasmastrahls selbst eingesetzt werden, mit dem Nachteil der Temperaturkontrolle über die Enthalpie/Temperatur des Plasmastrahls. Vorteilhaft erfolgt diese Anpassung unter Schaffung variabler Plasmabedingungen durch Variation der Plasmaleistung. Z.B. wird eine Basisleistung zwischen 30 kWatt und 200 kWatt je nach erforderlicher Prozessdauer und Verdampfung/Fragmentierungsenthalpie der jeweiligen Metallboride variiert. Da die zu beschichtenden Basisstrukturen eine elektrische Leitfähigkeit im Bereich typischer Heizleiter aufweisen, ist eine elektrische Heizung der gesamten Struktur ebenfalls möglich. Die Temperaturen des zu beschichtenden Körpers während des Beschichtungsprozesses betragen vorzugsweise zwischen 300°C und 1400 °C , weiter vorzugsweise zwischen 500°C und 1100°C. Die Temperaturen werden vorzugsweise durch Thermoelemente kontrolliert und der Heizprozess wird vorzugsweise durch Variation von Heizstrom/Heizspannung auf den Sollbereich geregelt.

5. Am Beispiel eines Bauteils für eine Raketenbrennkammer mit Schubdüse kann die Beschichtung von einer beliebigen Seite aus im Plasmastrahl erfolgen. Zur Erhöhung der Effizienz können Strömungskörper vorgesehen werden, die das Plasma mit dem Clusterstrahl mehr in Richtung zu beschichtender Wand drücken. Dadurch kann mehr Beschichtungsmaterial umgesetzt und die Prozesseffizienz erhöht werden.

6. Die derart hergestellten Metall-Boridschichten auf den faserkeramischen Basisstrukturen weisen vorteilhaft Dicken zwischen 0,1 µm und 200µm auf.

Im Folgenden werden weitere bevorzugte Ausgestaltungen und deren Vorteile zusammenfassend erläutert.

Während des Betriebes müssen Brennkammern, z.B. von Raumschubfahrzeugen, sehr hohen thermo-mechanischen und thermo-chemischen Belastungen Stand halten. Aufgrund der ihres geringen Gewichts und ihrer hohen Temperaturstabilität sind keramische Verbundmaterialien, insbesondere keramische Faserverbundmaterialien - z.B. CMC-Materialien (Ceramic Matrix Composite) wie insbesondere Cf/SiC- Material erhältlich durch einen PIP-Prozess (Polymer-Infiltration-Pyrolyse-Prozess) - vielversprechende Materialien für derartige Anwendungen.

Zum Schutz von Fasern, wie z.B. Kohlenstofffasern, und der Matrix, z.B. SiC-Matrix, gegen Oxidation und/oder Ablation, insbesondere oberhalb 1650°C, wird die Anwendung einer EBC-Beschichtung - Environmental Barrier Coating - auf dem Verbundmaterial vorgeschlagen. Bevorzugt wird eine geeignete UHTC-Beschichtung - Ultra High Temperature Coating - basierend aus einem Metall-Halbmetall-Verbindung, insbesondere aus einem Metallborid, wie insbesondere ZrB₂, vorgeschlagen.

Mikrostrukturen, Aufbau und Zusammensetzung und Adhäsionsverhalten der entwickelten Beschichtungen wurden an flachen Proben untersucht. Es konnte eine dichte und adhärente ZrB₂-Beschichtung erzeugt werden, wobei die Dicke von bisher von etwa 300 nm bis zu 20 µm verbessert werden konnte. Weiter wurden das Oxidations- und Thermoschock-Verhalten sowie die Ablationswiderstandsfähigkeit bei erhöhten Temperturen durch einen Langzeitmaterialtest in der Testeinrichtung ERBURIG (Environmental Relevant Burner Rig test facility) der Airbus Group unter Verwendung von Kerosin und Sauerstoff als Brennstoff zum Erzeugen einer Brennkammer-ähnlichen Umgebung untersucht. Vortests an recht dünnen Beschichtungen (ca. 2µm) zeigten, dass die Beschichtung eine gute Adhäsion während der Tests aufwies und daher ein sehr vielversprechendes Material für die geplanten Anwendungen ist.

Es werden Strukturen für Hochtemperaturanwendungen und insbesondere ein Aufbau von Hochtemperaturstrukturen mit dem Anwendungshintergrund technische Verbrennungen (z.B. Raketentriebwerke, Gasturbinen, Kolbenmotoren) vorgeschlagen.

Bevorzugte Verwendungen finden sich insbesondere in der Luft- und Raumfahrt sowie im Bau von Kraftmaschinen und/oder Fahrzeugen oder deren Antrieben. Z.B. sind die Hochtemperaturstrukturen im Bereich Brennkammer -Schubdüse bei Raketentriebwerken einzusetzen. Darüber hinaus bestehen Anwendungsmöglichkeiten bei Fluggasturbinen sowie Kolbenmaschinen (Hub- und Kreiskolbenmotoren). Weitere bevorzugte Verwendungen sind Hyperschallantriebe, Hyperschall-Vehicles, Thermalschutzsysteme beim Wiedereintritt aus dem Weltraum in die Atmosphäre usw...

Insbesondere wird mit den hier vorgeschlagenen Strukturen eine Erweiterung des Temperatur-Einsatzbereichs für Brennkammer und Schubdüse bei Raketenmotoren sowie Gasturbinen- Brennkammer und/oder Hochdruckturbine erreicht.

Um Strukturen zu schaffen, die Hochtemperaturanwendungen mit höheren Prozesstemperaturen und schwierigen chemischen Bedingungen Stand halten, schafft die Erfindung eine Struktur für Hochtemperaturanwendungen, umfassend eine Grundstruktur, die ein keramisches Verbundmaterial aufweist und eine Beschichtung aus einer Metall-Halbmetallverbindung, einem Metallborid, einem Metallcarbid, einem Metallnitrid oder Mischungen daraus. Als Metallkomponente ist vorzugsweise ein Übergangsmetall vorgesehen. Weiter wurden ein Herstellverfahren sowie eine Beschichtungsvorrichtung zur Verwendung darin beschrieben.

### Weitere Ausführungsbeispiele

### 1. Herstellung einer Struktur mit einer Grundstruktur aus C_{f}/SiC und einer Beschichtung aus Zirconiumborid

### 1.1 Herstellung der Grundstruktur aus C_{f}/SiC

Cf/SiC ist ein keramisches Verbundmaterial, das eine Matrix aus Siliciumcarbid (SiC) umfasst, in die Carbonfasern eingebettet sind (SiCARBON^{™} von der Airbus Group). In einem vorbereitenden Schritt werden kontinuierliche Carbonfasern (Typ T800HB-6000-40B, Toray Industries, INC., Japan) durch chemische Gasphasenabscheidung (CVD) mit einer 350 nm dicken Schicht aus pyrolytischem Kohlenstoff (pyC) beschichtet, wodurch eine optimierte Grenzfläche zwischen Faser und Matrix erhalten wird. Die so beschichteten Carbonfasern werden durch das Polymerinfiltrationspyrolyse-Verfahren (PIP-Verfahren) in eine SiC-Matrix eingebracht. Beim PIP-Verfahren werden Bündel aus den beschichteten Carbonfasern mit einem vorkeramischen Aufschlämmungssystem getränkt, wonach die Filamente aufgewickelt werden und unidirektionelle Prepregs erhalten werden. Anschließend werden die Prepregs laminiert und unter Druck in einem Autoklaven (T = 100-300 °C, p = 10-20 bar) vernetzt. Die so erhaltenen Grünkörper-Proben werden in einem Pyrolyseschritt bei 1100-1700 °C unter Stickstoff in das keramische Verbundmaterial aus SiC-Matrix mit eingebetteten Carbonfasern umgewandelt. Da das Polymer bei der Pyrolyse schrumpft, hat die resultierende SiC-Matrix eine Porosität von 40 bis 45 Vol-%. Durch dreimaliges Wiederholen des Tränkschritts und erneute Pyrolyse wird die Porosität gesenkt (Dichte: 1,78 g/cm³, Fasergehalt: 45 Vol.-%, Porosität: 23 Vol.-%). Anschließend werden Abschnitte mit einer Größe von 100 x 100 mm² hergestellt, die unter Verwendung einer Diamantscheibensäge (DIADISC 6200, MUTRONIC Präzisionsgerätebau GmbH & Co. KG, Germany) zugeschnitten werden.

### 1.2 Beschichtung des keramischen C_{f}/SiC-Verbundmaterials mit Zirconiumborid

Die Beschichtung erfolgt durch das sogenannte "High Performance Plasma Coating"-Verfahren (HPPC-Verfahren). Zur Vorbereitung werden die Cf/SiC-Proben jeweils 15 min in Wasser und Isopropanol gereinigt und dann bei 90 °C getrocknet. Anschließend wird die Plasmabeschichtung mit dem in Fig. 2 dargestellten Lichtbogenbrenner 4 durchgeführt, der in die in Fig. 3 dargestellte Beschichtungsapparatur integriert ist. Während der Beschichtung wird in dem Vakuumtank 10 der Beschichtungsapparatur ein extrem heißes Wasserstoff-Argon-Plasma (T > 10 000 K) erzeugt. Zirconiumborid-Pulver (ZrB₂, Grade B, Lieferant: HC Starck, Germany) wird in die heißeste Zone innerhalb des Plasmajets gegeben. Das Gemisch aus keramischem Pulver und Plasma wird in Richtung des Flachprobenhalters 11 beschleunigt, wo es unter Ausbildung der ZrB₂-Beschichtung auf die Cf/SiC-Abschnitte auftrifft.

### 2. Variation der Beschichtungszeit

Das Beschichtungsexperiment aus Abschnitt 1.1. wird viermal wiederholt. Die Beschichtungszeit beträgt 12, 60, 90 bzw. 120 s. Die Dicke d der ZrB₂-Schicht wächst in etwa linear mit der Beschichtungszeit an (d = 3 µm für t = 12 s; d = 8 µm für t = 60 s; d = 16 µm für t = 90 s; d = 20 µm für t = 120 s). Die erhaltenen ZrB₂-Beschichtungen zeigen unabhängig von der Beschichtungszeit eine relativ dichte Struktur. Die Beschichtungen sind spröde und zeigen Risse. Es wird angenommen, dass dies durch die unterschiedlichen thermischen Ausdehnungskoeffizienten von ZrB₂ (5,9 x 10⁻⁶ K⁻¹) und von Cf/SiC (in der Ebene 2 x 10⁻⁶ K⁻¹) verursacht wird

### 3. Beschichtung des keramischen C_{f}/SiC-Verbundmaterials mit eine Beschichtungspulver aus 90 Gew.-% Zirconiumborid und 10 Gew.-% Siliciumcarbid

Das Beschichtungsexperiment gemäß Abschnitt 1.2 wird mit einem Beschichtungspulver wiederholt, das 90 Gew.-% ZrB₂ und 10 Gew.-% SiC umfasst. Der thermische Ausdehnungskoeffizient von SiC beträgt 4,3 x 10⁻⁶ K⁻¹. Die Beschichtungsdauer beträgt 90 s. Die SEM-Untersuchung der Beschichtungen ergibt, dass die ZrB₂/SiC-Beschichtung weniger dicht und poröser ist als die reine ZrB₂-Beschichtung. Auf der äußerster Oberfläche der Beschichtung sind einzelne Partikel erkennbar. Die Anzahl an Rissen ist deutlich geringer, verglichen mit der Beschichtung aus reinem ZrB₂. Die Beschichtung haftet besser am Cf/Sic-Verbundmaterial. Es wird angenommen, dass sowohl die Anpassung des thermischen Ausdehnungskoeffizienten an das Cf/SiC-Verbundmaterial als auch die erhöhte Porosität zur Verringerung der thermischen Spannungen beim Abkühlen der Proben von 1000 - 2000 °C beiträgt.

Somit wird unter den gegebenen Versuchsbedingungen durch die Beimengung von 10 Gew.-% SiC zum ZrB₂-Beschichtungspulver eine Beschichtung mit verbesserten Eigenschaften erhalten.

Weitere Ausführungsformen und Einzelheiten zu möglichen Ausgestaltungen der Erfindung sowie deren vorteilhaften Ausführungsformen sind in der Anlage beschrieben. Die Anlage ist ein wissenschaftliches Paper mit dem Titel "Ultra High Temperature Ceramic Coatings for Environmental Protection of Cf/SiC Composites" von F. Uhlmann, C. Wilhelmi, S. Beyer, S. Schmidt-Wimmer, S. Laure beigefügt, in dem die hier beschriebenen Strukturen, Verfahren zur Herstellung der Strukturen und Vorrichtungen ebenfalls beschrieben werden. Diese bildet ausdrücklichen Teil der hiesigen Offenbarung und wird durch Bezugnahme inkorporiert.

## Patentansprüche

1. Struktur (1) für Hochtemperaturanwendung, umfassend eine Grundstruktur (2), die ein keramisches Verbundmaterial aufweist und eine Beschichtung (3) aus einem Beschichtungsmaterial, das wenigstens ein Metallborid und wenigstens ein Metallcarbid enthält.

2. Struktur (1) nach Anspruch 1, **dadurch gekennzeichnet, dass** die Beschichtung (3) eine gradierte Oberfläche aufweist.

3. Struktur (1) nach Anspruch 1 oder 2,
**dadurch gekennzeichnet,**
**dass** die Grundstruktur (2) Fasern und eine Matrix aufweist und/oder dass die Beschichtung (3) eine Dicke von 0,1 µm bis 200 µm aufweist.

4. Struktur (1) nach Anspruch 3,
**dadurch gekennzeichnet,**
a) **dass** die Fasern gebildet sind aus einem oder mehreren Fasermaterialien, die ausgewählt sind aus einer Gruppe von Fasermaterialien, die C, keramische Materialien, SiC, HfC, ZrC, TaC, TiC, ZrB₂, HfB₂, TiB₂, TaB₂ und NbB₂ und nitridische Materialien umfasst, und/oder
b) **dass** die Matrix gebildet ist aus einem oder mehreren Matrixmaterialien, die ausgewählt sind aus einer Gruppe von Matrixmaterialien, die C, keramische Matrixmaterialien, SiC, SiSiC, HfC, ZrC, TaC, TiC, ZrB₂, HfB₂, TiB₂, TaB₂ und NbB₂ und nitridische Materialien umfasst.

5. Struktur (1) nach einem der voranstehenden Ansprüche,
**dadurch gekennzeichnet,**
**dass** die Beschichtung (3) ausgewählt ist aus einem oder mehreren der Beschichtungsmaterialien einer Gruppe von Beschichtungsmaterialien, die SiC, HfC, ZrC, TaC, TiC, ZrB₂, HfB₂, TiB₂, TaB₂ und NbB₂ umfasst.

6. Struktur (1) nach einem der voranstehenden Ansprüche,
**dadurch gekennzeichnet,**
**dass** die Beschichtung (3) aus ZrB₂ und SiC gebildet ist.

7. Struktur (1) nach einem der voranstehenden Ansprüche,
**dadurch gekennzeichnet,**
**dass** die Grundstruktur (2) Carbonfasern C_{f} und eine SiC-Matrix umfasst.

8. Struktur (1) nach einem der voranstehenden Ansprüche,
**dadurch gekennzeichnet,**
**dass** die Beschichtung (3) wenigstens eine glasartige Substanz und/oder eine Mischung eines Metalloxids mit Boroxid oder Halbmetalloxid an ihrer Oberfläche aufweist.

9. Struktur (1) erhältlich durch ein Verfahren zum Herstellen einer Struktur (1) für Hochtemperaturanwendungen umfassend eine Grundstruktur, die ein keramisches Verbundmaterial aufweist und eine Beschichtung (3), wobei das Verfahren umfasst:
a) Bereitstellen einer Grundstruktur (2) aus einem keramischen Verbundmaterial, insbesondere keramischen Faserverbundmaterial, und
b) Beschichten der Grundstruktur (2) mit einer Ultrahochtemperaturkeramik-Beschichtung (3) aus einem Beschichtungsmaterial, das wenistens eine Metall-Halbmetallverbindung, wenigstens ein Metallborid, wenigstens ein Metallcarbid und/oder wenigstens ein Metallnitrid enthält, durch
- Einbauen der Grundstruktur (2) in eine Vakuum-Prozesskammer (10) für Plasma-Strahltechniken;
- Bereitstellen eines Plasmabrenners (4) mit einer Kathode (5), einem länglichen Plasmakanal stromab einer Kathode (5) zum Leiten eines Plasmastrahls und einer Überschalldüse (9);
- Einbringen des Beschichtungsmaterials in den länglichen Plasmakanal und Bilden einer Gasmischung in dem länglichen Plasmakanal;
- Expandieren der Gasmischung mit Beschichtungsmaterial über die Überschalldüse (9); und
- Plasmabeschichten der Grundstruktur (2) mit dem Beschichtungsmaterial.
